# EUROPEAN PATENT APPLICATION

(11) **EP 2 712 276 A1**
(43) Date of publication of application: **26.03.2014**
(21) Application number: 12786614.3
(22) Date of filing: 15.02.2012
(51) Int. Cl.: H05B 33/22, G09F 9/30, H01L 27/32, H01L 51/50, H05B 33/10

(54) **ORGANIC LIGHT-EMITTING ELEMENT, METHOD FOR MAKING ORGANIC LIGHT-EMITTING ELEMENT, DISPLAY DEVICE AND ILLUMINATION DEVICE**

(30) Priority: 19.05.2011 JP 2011112631
(71) Applicant: Showa Denko K.K., Tokyo 105-8518 (JP)
(72) Inventor: SAKO, Kanjiro, Tokyo 105-8518 (JP); MASUYA, Kyousuke, Tokyo 105-8518 (JP); TAJIMA, Masaru, Tokyo 105-8518 (JP); HIROSE, Katsumasa, Tokyo 105-8518 (JP)
(74) Representative: Strehl Schübel-Hopf & Partner
(86) International application number: PCT/JP2012/053487
(87) International publication number: WO 2012/157303

(57) **Abstract**

An organic light-emitting element having a high light extraction efficiency and a high light emission efficiency is provided, by an organic light-emitting element (10) including: a transparent anode layer (12) formed on a substrate (11); a first penetrating portion (16) formed to penetrate the anode layer (12); a dielectric layer (13) formed to cover an upper surface of the anode layer (12) and an inner surface of the first penetrating portion (16); a second penetrating portion (17) formed to penetrate the anode layer (12) and the dielectric layer (13); an organic compound layer (14) that includes a light emitting layer formed to cover at least an inner surface of the second penetrating portion (17); and a cathode layer (15) formed on the organic compound layer (14), wherein a refractive index of the dielectric layer (13) is lower than a refractive index of the anode layer (12).

## Description

### Technical Field

The present invention relates to an organic light-emitting element used for a display device or an illumination device.

### Background Art

An organic light-emitting element using an organic compound as a light-emitting body is expected to be applied for illumination purpose because of the characteristics of surface light source thereof, and technologies on extracting the emitted light toward outside are actively developed for the purpose of further high-efficiency.

An organic light-emitting element with a structure in which multiple fine holes are formed in an optically permeable electrode formed on a transparent substrate and a light emitting layer is formed on the electrode and in the fine holes is proposed as a technique for improving light extraction efficiency from the light emitting layer to outside of the organic light-emitting element.

Patent Document 1 discloses an organic light-emitting element in which a cavity penetrating an electrode and a dielectric layer is formed in a laminated structure of the electrode and the dielectric layer and a light emitting layer is formed in the cavity.

Patent Document 2 discloses an organic light-emitting element in which an asperity is provided on a surface of an electrode and a light emitting layer is formed on the electrode and in the asperity.

### Citation List

### Patent Literature

Patent Document 1: Japanese Patent Application Unexamined Publication (Translation of PCT Application) No. 2010-509729
Patent Document 2: Japanese Patent Application Laid-Open Publication No. 2004-311419

### Disclosure of Invention

### Technical Problem

However, in the organic light-emitting element in which the light emitting layer is formed in the cavity, there are some cases where light emitted inside of the cavity enters into a transparent electrode without entering into a dielectric layer. Then, since a refractive index of the transparent electrode and that of the dielectric layer are generally approximate each other, path of light is not efficiently changed, thereby the light extraction efficiency to outside of the organic light-emitting element has been not sufficient. Further, in the organic light-emitting element in which the asperity is formed on the surface of the electrode, although it is possible to improve an efficiency of extracting the light, which enters from a light extracting surface and the other side surface of the electrode provided with the asperity, from the light extracting surface with various angles, an efficiency of extracting the light, which is emitted inside of concave portions and enters into a side surface of the electrode inside of the concave portions, to outside of the organic light-emitting element has not been sufficient.

### Solution to Problem

To address the above problem, the present inventors have found that, with a configuration of an organic light-emitting element in which a dielectric layer having a lower refractive index than a transparent electrode layer is arranged on a path of light that is emitted from a light emitting layer inside of a penetrating portion and enters into the transparent electrode layer, light which has not been extracted to outside of the organic light-emitting element is able to be efficiently extracted, and completed the invention.

An organic light-emitting element according to the present invention includes; a first electrode layer that is transparent and formed on a substrate; a first penetrating portion that is formed to penetrate the first electrode layer; a dielectric layer that is formed to cover an upper surface of the first electrode layer and an inner surface of the first penetrating portion; a second penetrating portion that is formed to penetrate the first electrode layer and the dielectric layer; an organic compound layer that includes a light emitting layer formed to cover at least an inner surface of the second penetrating portion; and a second electrode layer that is formed on the organic compound layer, wherein a refractive index of the dielectric layer is lower than a refractive index of the first electrode layer.

Here, an upper surface of the dielectric layer is preferably formed to be a planar shape, and the refractive index of the dielectric layer is preferably lower than a refractive index of the organic compound layer.

Moreover, the first penetrating portion and the second penetrating portion preferably have a circular shape or a polygonal shape with the maximum width of 10 µm or less in an area surface of the first electrode layer, and the first penetrating portion and the second penetrating portion are preferably formed 10³ to 10⁸ per 1 mm square in an arbitrary area surface of the first electrode layer.

Method for making an organic light-emitting element according to the present invention includes; a first electrode layer forming process in which a first electrode layer is laminated on a substrate; a first penetrating portion forming process in which a first penetrating portion is formed to penetrate the first electrode layer; a dielectric layer forming process in which an upper surface of the first electrode layer and an inner surface of the first penetrating portion are covered with a dielectric body; a second penetrating portion forming process in which a second penetrating portion is formed to penetrate the first electrode layer and the dielectric layer; an organic compound layer forming process in which an organic compound layer that includes a light emitting layer formed to cover at least an inner surface of the second penetrating portion is formed; and a second electrode layer forming process in which a second electrode is formed on the organic compound layer.

A display device according to the present invention includes the organic light-emitting element described above.

An illumination device according to the present invention includes the organic light-emitting element described above.

### Advantageous Effects of Invention

According to the present invention, an organic light-emitting element that has high light extraction efficiency and high light emission efficiency can be provided.

### Brief Description of Drawings

FIG. 1 is a partial cross-sectional view for illustrating a specific example of an organic light-emitting element to which the exemplary embodiment is applied;
FIG. 2 is a partial cross-sectional view for illustrating a specific example of an organic light-emitting element and a path of light that is extracted from an organic compound layer of the exemplary embodiment to a downside of a substrate;
FIGS. 3A to 3F are diagrams for illustrating the method for making the organic light-emitting element to which the exemplary embodiment is applied;
FIG. 4 is a diagram for illustrating an example of a display device using the organic light-emitting element according to the exemplary embodiment; and
FIG. 5 is a diagram for illustrating an example of an illumination device having the organic light-emitting element according to the exemplary embodiment.

### Description of Embodiments

### (Organic light-emitting element)

Hereinafter, an exemplary embodiment of the present invention will be described in detail with reference to the attached drawings.

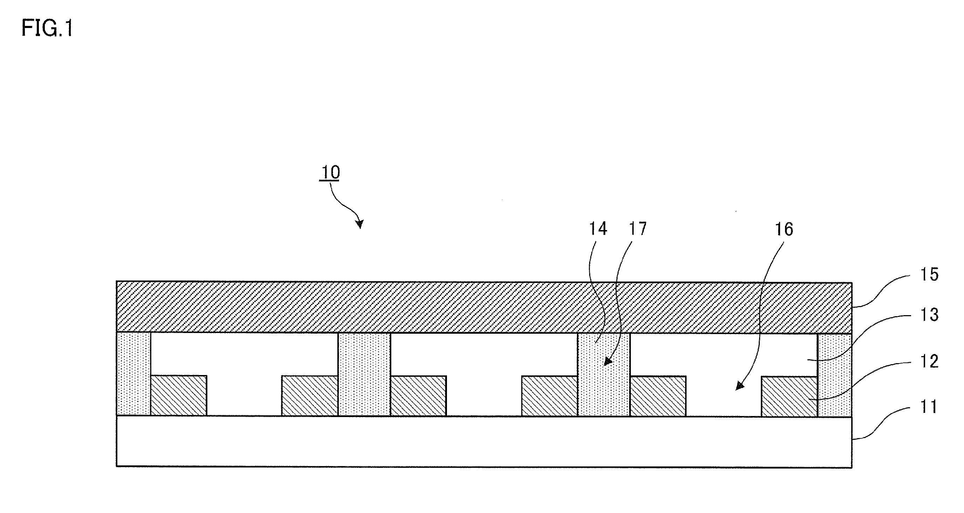

FIG. 1 is a partial cross-sectional view for illustrating a specific example of an organic light-emitting element to which the exemplary embodiment is applied.

An organic light-emitting element 10 shown in FIG. 1 has a configuration in which a substrate 11, an anode layer 12 as a first electrode layer for injecting holes, which is transparent and formed on the substrate 11 in a case where the substrate 11 side is assumed to be the downside, a dielectric layer 13 that changes path of light having entered and has a function of insulating at least a part between the anode layer 12 and a cathode layer 15, and the cathode layer 15 as a second electrode for injecting electrons are stacked. It should be noted that the organic light-emitting element of the exemplary embodiment is not limited to the configuration of the above FIG. 1, for example, the transparent first electrode layer and the second electrode may be a cathode layer and an anode layer, respectively. Hereinafter, the organic light-emitting element of the exemplary embodiment will be explained by employing the configuration of the FIG. 1 as a specific example.

In the organic light-emitting element 10, plural first penetrating portions 16 formed to penetrate the anode layer 12 is provided. Further, in the organic light-emitting element 10, in addition to the first penetrating portions 16, plural second penetrating portions 17 formed to penetrate both the anode layer 12 and the dielectric layer 13 are provided. The dielectric layer 13 is formed on an upper surface of the anode layer 12 and inside of the first penetrating portion 16. Further, inside of the second penetrating portion 17, an organic compound layer 14 that includes a light emitting layer formed to cover at least the inner surface of the second penetrating portions 17 is formed.

In the present exemplary embodiment, since the organic compound layer 14 is composed of a single layer, the organic compound layer 14 is the light emitting layer. As the organic compound layer 14 emits light, a light emitting surface of the organic light-emitting element 10 is formed.

The substrate 11 is a base material that serves as a support body for forming the anode layer 12, the dielectric layer 13, the organic compound layer 14 and the cathode layer 15. For the substrate 11, a material that satisfies mechanical strength required for the organic light-emitting element 10 is used.

In the case where the light is to be taken out from the substrate 11 side of the organic light-emitting element 10, the material used for the substrate 11 is required to be transparent to the light emitted from the light emitting layer. Specific examples include: glasses such as sapphire glass, soda lime glass and quartz glass; transparent resins such as acrylic resins, polycarbonate resins and polyester resins; silicon resins; and transparent metallic oxide such as aluminum nitride and alumina. In a case of using, as the substrate 11, a resin film or the like made of the aforementioned transparent resins, it is preferable that permeability to gas such as moisture and oxygen is low. In a case of using a resin film or the like having high permeability to gas, a thin film having a barrier property for inhibiting permeation of gas is preferably formed as long as the light transmission is not largely lost.

In a case where it is unnecessary to take out the light from the substrate 11 side of the organic light-emitting element 10, the material of the substrate 11 is not limited to the ones which are transparent to the visible light, and may be opaque to the visible light. The specific examples of such material include: a simple substances such as silicon (Si), copper (Cu), silver (Ag), gold (Au), platinum (Pt), tungsten (W), titanium (Ti), tantalum (Ta) or niobium (Nb); alloys thereof; or stainless steel. The specific examples of the material of the substrate 11 also include oxides such as SiO₂, Al₂O₃ and the like; and a semiconductor material such as n-Si and the like. As materials for an opaque substrate 11, metal materials having high light reflectivity are preferable for extracting more light emitted from the light emitting layer to outside of the organic light-emitting element 10.

Although the thickness of the substrate 11 depends on the required mechanical strength, it is preferably 0.1 mm to 10 mm, and more preferably 0.25 mm to 2 mm.

With an application of voltage between the anode layer 12 and the cathode layer 15, holes are injected from the anode layer 12 to the organic compound layer 14. Materials used for the anode layer 12 are necessary to have electric conductivity. Specifically, it is preferable that the materials have high work function and the work function is not less than 4.5 eV. In addition, it is preferable that the electric resistance is not notably changed for an alkaline aqueous solution.

The materials for forming the anode layer 12 are, for inducing the light having entered from the organic compound layer 14 which is in contact with the anode layer 12 in the second penetrating portion 17 to the dielectric layer 13 in the first penetrating portion 16, required to have a permeability to this light. As the materials satisfying such requirements, metal oxides are preferable, and indium tin oxide (ITO), indium zinc oxide (IZO) and tin oxide are exemplified. The thickness of the anode layer 12 is formed to be, for example, 2 nm to 2 µm. However, from a view point of high conductivity, the thickness is preferably 50 nm or more, and from a view point of easily forming the first penetrating portion 16 and the second penetrating portion 17 to have uniform shape and size in the thickness direction, the thickness is preferably 500 nm or less. Note that, the work function can be measured by, for example, an ultraviolet photoelectron spectroscopy.

The dielectric layer 13 refracts the light having entered from the organic compound layer 14 at an interface between the organic compound layer 14 and the anode layer 12 so that the light is easily extracted to outside of the organic light-emitting element 10.

In the exemplary embodiment, the dielectric layer 13 has insulating properties. By having insulating properties, the dielectric layer 13 can separate the anode layer 12 from the cathode layer 15 with a predetermined gap therebetween and insulate them, while making light emitting materials included in the organic compound layer 14 emit light by applying voltage between the anode layer 12 and the cathode layer 15. Thus, materials for forming the dielectric layer 13 are required to be made of materials having high resistivity, and the electric resistivity thereof is required to be not less than 10⁸ Ωcm, and preferably not less than 10¹² Ωcm. Specific examples of the materials include: metal nitrides such as silicon nitride, boron nitride and aluminum nitride; metal oxides such as silicon oxide (silicon dioxide) and aluminum oxide; and metal fluorides such as sodium fluoride, lithium fluoride, magnesium fluoride, calcium fluoride and barium fluoride; and in addition, polymer compounds such as polyimide, polyvinylidene fluoride and parylene; and spin-on glasses (SOG) such as poly (phenylsilsesquioxane) can be used.

The light extraction efficiency is especially improved when the refractive index of the dielectric layer 13 is lower than the refractive index of the anode layer 12 and the refractive index of the organic compound layer 14. Therefore, as materials for forming the dielectric layer 13, it is preferable to select materials having a refractive index lower than that of any materials for forming each layer of the anode layer 12 and the organic compound layer 14, which are configured with a single layer or plural layers.

As a result, it is possible to form the dielectric layer 13 so that the refractive index of the dielectric layer 13 is lower than both the refractive index of the anode layer 12 and the refractive index of the organic compound layer 14. In more detail, the refractive index of the dielectric layer 13 is preferably lower than the refractive index of the anode layer 12 and the refractive index of the organic compound layer 14 by 0.1 or more, and more preferably, by 0.2 or more.

Here, in order to manufacture, with high reproducibility, the organic light-emitting element 10 that is less likely to be short-circuited and less likely to leak a current, it is preferable that the thickness of the dielectric layer 13 is thicker. On the other hand, the thickness of the dielectric layer 13 is preferably not more than 1 µm in order to suppress the entire thickness of the organic light-emitting element 10. In addition, since the voltage necessary to emit light is lower as the distance between the anode layer 12 and the cathode layer 15 is shorter, the dielectric layer 13 is preferably set to be thin from this viewpoint. However, if it is too thin, dielectric strength becomes possibly insufficient against the voltage for driving the organic light-emitting element 10. Here, in a state where the dielectric layer 13 is formed between the electrodes to be a layer shape in which a penetrating portion is not formed, the dielectric strength is preferably not more than 0.1 mA/cm² in current density of a current passing in this dielectric layer when the voltage higher by 2V than the voltage in driving for the organic light-emitting element 10 is applied, and more preferably not more than 0.01 mA/cm². The thickness of the dielectric layer 13 that satisfies these requirements is preferably not more than 750 nm as the upper limit, more preferably not more than 400 nm, and still more preferably not more than 200 nm. The thickness of the dielectric layer 13 is preferably not less than 15 nm as the lower limit, more preferably not less than 30 nm, and still more preferably not less than 50 nm. Here, the thickness of the dielectric layer 13 is a surface-to-surface distance between the upper surface of the anode layer 12 and the dielectric layer 13.

An upper surface of the dielectric layer 13 is preferably formed to be a planar shape. For example, in a case where an asperity is formed on the upper surface of the dielectric layer 13 and the organic compound layer 14 is formed thereon, a thick film of an organic compound composing the organic compound layer 14 is likely to be formed in a recessed portion. Therefore, light is absorbed in that portion, or light in a direction to a light extraction surface is refracted and a path of the light is changed to a horizontal direction, thereby the light is confined in the organic light-emitting element 10 to lower the light extraction efficiency.

The organic compound layer 14 is composed of a single or laminated plural organic compound layers including a light emitting layer, and formed to cover at least an inner surface of the plural second penetrating portions 17. The light emitting layer includes a light emitting material that emits light when the voltage is applied between the anode layer 12 and the cathode layer 15. As such light emitting materials, either low-molecular compound or high-molecular compound may be used. In the present exemplary embodiment, as a light emitting material, it is preferable to use phosphorescent organic compounds as a light-emitting organic material and metal complexes. Among the metal complexes, there exist ones that show phosphorescence, and such metal complexes are also preferably used. In the present exemplary embodiment, in particular, it is exceptionally desirable to use cyclometalated complexes in terms of improving light emission efficiency. As the cyclometalated complexes, complexes of Ir, Pd, Pt and the like including ligands such as 2-phenylpyridine derivatives, 7, 8-benzoquinoline derivatives, 2-(2-thienyl)pyridine derivatives, 2-(1-naphthyl)pyridine derivatives, 2-phenylquinoline derivatives are provided, and iridium (Ir) complexes are especially preferred. The cyclometalated complexes may include ligands other than the ligands required to form the cyclometalated complexes. Note that the cyclometalated complexes are preferable in terms of improving light emission efficiency because compounds that emit light from triplet exciton are included therein.

Moreover, specific examples of light-emitting polymer compounds include: poly-p-phenylenevinylene (PPV) derivatives such as MEH-PPV (poly[2-methoxy-5-(2-ethylhexyloxy)-1,4-phenykenevinylene]); polymer compounds of a n-conjugated system such as polyfluorene derivatives and polythiophene derivatives; polymers introducing low-molecular pigments and tetraphenyldiamine or triphenylamine to a main chain or a side chain and the like. The light-emitting polymer compounds and light-emitting low-molecular compounds can be used in combination.

The light emitting layer includes the light-emitting material and a host material, and the light emitting material is dispersed in the host material in some cases. It is preferable that the host material has charge transporting properties, and it is also preferable that the host material is a hole-transporting compound or an electron-transporting compound.

The organic compound layer 14 may include a hole-transporting layer to receive a hole from the anode layer 12 and transport the hole to the light emitting layer. The hole-transporting layer is provided between the anode layer 12 and the light emitting layer.

As the hole-transporting materials for forming the hole-transporting layer, publicly known materials can be used, and examples thereof include low molecular triphenylamine derivatives such as: TPD (N,N'-diphenyl-N,N'-bis(3-methylphenyl)-1,1'-biphenyl-4,4'diamine)a-NPD (4,4'-bis[N-(1-naphthyl)-N-phenylamino]biphenyl); and m-MTDATA (4,4',4"-tris(3-methylphenylphenylamino)triphenylamine). In addition, examples also include: polyvinylcarbazole; and triphenylamine derivative-based high-molecular compound polymerized by introducing a polymerizable functional group. The above hole-transporting materials may be used solely or by mixing two or more, and may be used by laminating different hole-transporting materials. The thickness of the hole-transporting layer depends on conductivity or the like of the hole-transporting layer, therefore it is not generally limited, however, it is preferably in the range of 1 nm to 5 µm, more preferably 5 nm to 1 µm, further preferably 10 nm to 500 nm.

To mediate a hole injection barrier, a hole injection layer may be provided between the above hole-transporting layer and the anode layer 12. As a material for forming the hole injection layer, publicly known materials such as copper phthalocyanine, a mixture of poly-ethylendioxythiophene (PEDOT) and polystyrene sulfonate (PSS) (PEDOT:PSS), fluorocarbon and silicon dioxide may be used, and a mixture of the hole-transporting materials used for the above hole-transporting layer and electron acceptors such as 2,3,5,6-tetrafluorotetracyano-1,4-benzoquinodimethane (F4TCNQ) may be used.

The above organic compound layer 14 may include an electron transporting layer for transporting an electron from the cathode layer 15 to the light emitting layer, between the light emitting layer and the cathode layer 15. The material which can be used for the electron transporting layer includes; quinolinic derivatives, oxiadiazole derivatives, perylene derivatives, pyridine derivatives, pyrimidine derivatives, quinoxaline derivatives, diphenylquinone derivatives, nitro displacement fluorene derivatives or the like. More specifically, tris(8-quinolinolato)aluminium (abbreviated expression: Alq), bis[2-(2-hydroxyphenyl)benzooxazolato]zinc, bis[2-(2-hydroxyphenyl)benzothiazolato]zinc, 2-(4-biphenylyl)-5-(4-tert-butylphenyl)-1,3,4-oxadiazol can be used.

Moreover, for the purpose of suppressing holes from penetrating the light emitting layer and efficiently recombining holes and electrons in the light emitting layer, a hole-block layer may be provided between the above electron transporting layer and the light emitting layer. This hole-block layer may be considered as one of layers included in the organic compound layer 14. In order to form the above hole-block layer, publicly known materials such as a triazine derivative, an oxadiazole derivative, a phenanthroline derivative or the like may be used.

The cathode layer 15 injects electrons into the organic compound layer 14 upon application of voltage between the anode layer 12 and the cathode layer 15. The cathode layer 15 is formed to cover the upper surface of the dielectric layer 13 and the upper surface of the organic compound layer 14, and successively formed on a whole surface of the light emitting surface.

The material used for the cathode layer 15 is not particularly limited as long as, similarly to that of the anode layer 12, the material has electrical conductivity; however, it is preferable that the material has a low work function and is chemically stable. The specific examples of the material include Al, MgAg alloy and alloys of Al and alkali metals such as AlLi and AlCa. The thickness of the cathode layer 15 is preferably in the range of 10 nm to 1 µm, and more preferably 50 nm to 500 nm. In a case where light emitted from the organic compound layer 14 is extracted from the substrate 11 side, the cathode layer 15 may be formed by an opaque material, however, if light is intended to be extracted from the cathode layer 15 side, the cathode layer 15 is necessary to be made of a transparent material such as

### ITO.

To lower the barrier for the electron injection from the cathode layer 15 into the organic compound layer 14 and thereby to increase the electron injection efficiency, a cathode buffer layer that is not shown in the figure may be provided adjacent to the cathode layer 15 and at a side of the organic compound layer 14. Metallic materials having a lower work function than the cathode layer 15 may be used for the cathode buffer layer. For example, the material thereof includes alkali metals (Na, K, Rb and Cs), alkaline earth metals (Sr, Ba, Ca and Mg), rare earth metals (Pr, Sm, Eu and Yb), one selected from fluoride, chloride and oxide of these metals and mixture of two or more selected therefrom. The thickness of the cathode buffer layer is preferably in the range of 0.1 nm to 50 nm, more preferably 0.1 nm to 20 nm, and still more preferably 0.5 nm to 10 nm.

The plural first penetrating portions 16 formed in the anode layer 12 have a function of increasing the light emitted to outside of the organic light-emitting layer 10 by changing the path of light emitted from the organic compound layer 14 with the dielectric layer 13 formed in the first penetrating portions 16, which will be described later.

Here, the shape of the first penetrating portion 16 is not particularly limited, however, for easily controlling the shape thereof, it is preferable that the shape of the recessed portion 16 is a cylindrical shape or a polygonal columnar shape such as square pole, for example. In these shapes, shape in an upper surface of the anode layer 12 may be varied in the thickness direction of the anode layer 12, or size of the shape may be varied. That is, the shapes may be, for example, conic, pyramid, conic trapezoid, or pyramid trapezoid. By arbitrarily selecting the shape of the first penetrating portion 16, it is possible to control light distribution or the like when the light emitted from the organic compound layer 14 is extracted outside.

In the partial cross-sectional view of FIG. 1, a side surface of the first penetrating portions 16 is formed to be perpendicular to a surface of the substrate 11, and the inclined angle of the side surface of the first penetrating portions 16 is 90 degrees, in this case. Note that the inclined angle is not limited thereto and may be appropriately changed according to the materials or the like used for the anode layer 12 or selection of etching method or the like, thereby the light extraction efficiency with which the light emitted from the organic compound layer 14 is extracted toward outside can be improved. In the present exemplary embodiment, depending on the kinds of materials for forming the anode layer 12, the inclined angle is preferably in the range of 60 degrees to 90 degrees, more preferably 70 degrees to 90 degrees, further preferably 75 degrees to 85 degrees, from a view point of high efficiency of extracting the light emitted from the organic compound layer 14.

For achieving high light emission efficiency, the size of the first penetrating portions 16 on the anode layer 12 (the maximum width of a shape in the surface of the anode layer 12) is preferably 10 µm or less. Moreover, from a view point of easy productivity, this size is preferably 0.1 µm or more, and more preferably 0.5 µm or more. Arrangement of the first penetrating portions 16 on the anode layer 12 may be regular one such as square-lattice pattern or hexagonal-lattice pattern, or may be irregular one. This arrangement is arbitrarily selected from view points of wavelength of light emitted from the organic compound layer 14, light distribution emitted from the organic light-emitting element 10, or spectral control.

The first penetrating portions 16 are preferably formed 10³ to 10⁸ per 1 mm square in an arbitrary area surface of the anode layer 12. In these range, the light that travels in the anode layer 12 along a direction parallel to the light extraction surface can be efficiently extracted to outside of the organic light-emitting element 10.

The plural second penetrating portions 17 are formed to penetrate the anode layer 12 and the dielectric layer 13. The organic compound layer 14 is formed inside the second penetrating portions 17, and the second penetrating portions 17 are light emitting area for emitting light by application of voltage between the anode layer 12 and the cathode layer 15. The second penetrating portions 17 are sufficient to penetrate the anode layer 12 and the dielectric layer 13, and the shape thereof may be cylindrical, polygonal columnar, conic, pyramid, conic trapezoid, or pyramid trapezoid. Further, an inclined angle of the second penetrating portions 17 is similar to the inclined angle of the first penetrating portions 16 described above, however, the inclined angle of the second penetrating portions 17 may be different between at a portion of the anode layer 12 and at a portion of the dielectric layer 13.

For achieving high light emission efficiency, the size of the second penetrating portions 17 on the dielectric layer 13 (the maximum width of a shape in the surface of the dielectric layer 13, in other words, the diameter of the minimum circle that encircles the shape) is preferably 10 µm or less. Moreover, from a view point of easy productivity, this size is preferably 0.1 µm or more, and more preferably 0.5 µm or more. Arrangement of the second penetrating portions 17 on the dielectric layer 13 may be regular one such as square-lattice pattern or hexagonal-lattice pattern, or may be irregular one. This arrangement is arbitrarily selected from view points of wavelength of light emitted from the organic compound layer 14, light distribution emitted from the organic light-emitting element 10, or spectral control. Further, for maximizing an improving effect of the light extraction efficiency by the first penetrating portions 16, the second penetrating portions 17 are preferably provided adjacent to the first penetrating portions 16.

The second penetrating portions 17 are preferably formed 10³ to 10⁸ per 1 mm square in an arbitrary area surface of the dielectric layer 13.

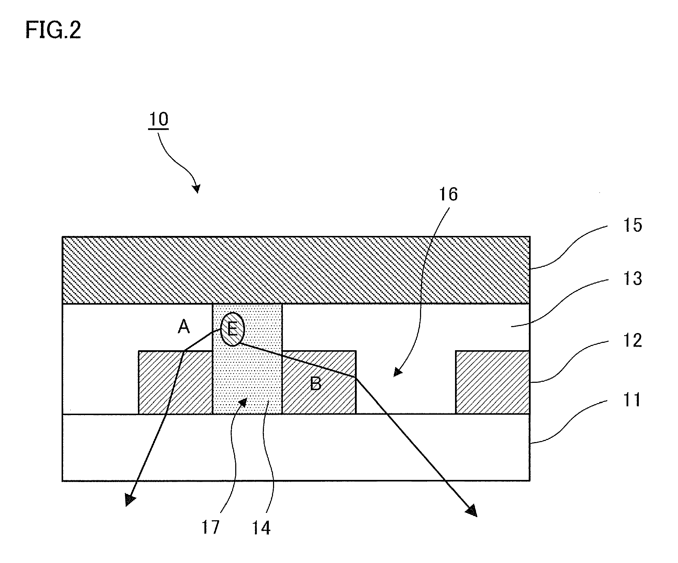

FIG. 2 is a partial cross-sectional view for illustrating a specific example of an organic light-emitting element 10 and a path of light that is extracted from an organic compound layer 14 of the exemplary embodiment to a downside of a substrate. Here, the refraction index of the substrate 11 is set to be approximately 1.4, the refraction index of the anode layer 12 is set to be approximately 1.7, the refraction index of the dielectric layer 13 is set to be approximately 1.4, and the refraction index of the organic compound layer 14 is set to be approximately 1.7.

An area E shown in the second penetrating portion 17 of FIG. 2 illustrates a light emitting area in the organic compound layer 14.

In path of A, the light having entered into the dielectric layer 13 in the approximately horizontal direction to the surface of the substrate 11 from the light emitting area E is refracted at the interface between the compound layer 14 and the dielectric layer 13 and at the interface between the dielectric layer 13 and the anode layer 12, and inflected in the approximately perpendicular direction to the surface of the substrate 11. It is possible to extract the light to outside the organic light-emitting element 10 without causing a total reflection at the interface of the air which is a side of the light extracting surface of the substrate 11 by passing thorough the dielectric layer 13 in this manner.

In path of B, the light having entered into the anode layer 12 in the approximately horizontal direction to the surface of the substrate 11 from the light emitting area E is refracted at the interface between the dielectric layer 13 and the anode layer 12 which are formed inside the first penetrating portions 16, and the path is changed to a degree which is closer to the direction of normal line of the substrate 11. As the result, it is possible to extract the light to outside the organic light-emitting element 10 because the light having reached the substrate 11 is more unlikely to cause a total reflection at the interface between the substrate 11 and the air compared to the case where the first penetrating portions 16 is not provided. It is possible to effectively extract the light, including the light whose extraction efficiency is not enough in the conventional organic light-emitting element, outside with the dielectric layer 13 formed inside of the first penetrating portions 16. In other words, in the organic light-emitting element 10 of the present exemplary embodiment, it is possible to improve the light extraction efficiency by providing the first penetrating portion 16.

It should be noted that, in the organic light-emitting element 10 described above in detail, in a case where the substrate 11 side is assumed to be the downside, a case where the anode layer 12 is formed downside and the cathode layer 15 is formed upside with the dielectric layer 13 interposed therebetween and facing each other is illustrated as a specific example, however, it is not limited thereto, and a configuration in which the anode layer 12 and the cathode layer 15 are replaced each other may be provided. That is, in a case where the substrate 11 side is assumed to be the downside, a configuration in which the cathode layer 15 is formed downside and the anode layer 12 is formed upside with the dielectric layer 13 interposed therebetween and facing each other may be provided.

### (Method for making organic light-emitting element)

Next, description will be given for a method of making the organic light-emitting element to which the exemplary embodiment is applied, while the organic light-emitting element 10 described with FIG. 1 is taken as an example.

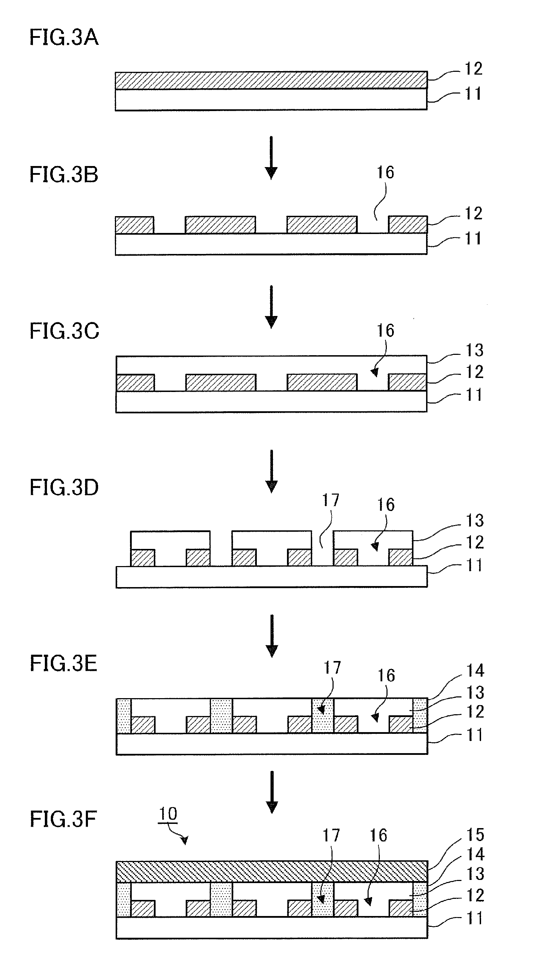

FIGS. 3A to 3F are diagrams for illustrating the method for making the organic light-emitting element 10 to which the exemplary embodiment is applied.

First, on the substrate 11, the anode layer 12 as a first electrode layer is formed (FIG. 3A: first electrode layer forming process). In the exemplary embodiment, a glass substrate is used as the substrate 11. Further, ITO is used as a material for forming the anode layer 12.

For forming the anode layer 12 on the substrate 11, a dry method such as; a resistance heating deposition method; an electron beam deposition method; a sputtering method; an ion plating method; and a CVD method or the like, and a wet method such as; a spin coating method; a dip coating method; an ink-jet printing method; a printing method; a spray-coating method; and a dispenser-printing method or the like may be used.

It should be noted that the process for forming the anode layer 12 can be omitted by using a so-called substrate with electrode in which ITO as the anode layer 12 has already been formed on the substrate 11.

Next, the first penetrating portions 16 are formed so as to penetrate the anode layer 12 formed in the process of FIG. 3A (FIG. 3B: first penetrating portion forming process).

For forming the first penetrating portions 16 and on the anode layer 12, a method using lithography may be used, for example. To form the first penetrating portions 16, first, a resist solution is applied on the dielectric layer 13 and then an excess resist solution is removed by spin coating or the like to form a resist layer. Thereafter, the resist layer is covered with a mask, in which a predetermined pattern for forming the first penetrating portions 16 is rendered, and is exposed with ultraviolet light (UV), an electron beam (EB) or the like. Then, the predetermined pattern corresponding to the first penetrating portions 16 is exposed onto the resist layer. Thereafter, light exposure portions of the resist layer are removed by use of a developing solution, exposed pattern portions of the resist layer are removed. By this process, the surface of the anode layer 12 is exposed so as to correspond to the exposed pattern portions.

Then, by using the remaining resist layer as a mask, exposed portions of the anode layer 12 are removed by etching. Either dry etching or wet etching may be used as the etching. Further, by combining isotropic etching and anisotropic etching at this time, the shape of the first penetrating portions 16 can be controlled. Reactive ion etching (RIE) or inductive coupling plasma etching is used as the dry etching, and a method of immersion in diluted hydrochloric acid, diluted sulfuric acid, or the like is used as the wet etching. Lastly, the residual resist layer is removed by using a resist removing solution, and the first penetrating portions 16 is formed on the anode layer 12.

Moreover, the first penetrating portions 16 can be formed by a method of nanoimprinting. Specifically, after forming the resist layer, a mask in which predetermined convex patterns to form a pattern are rendered is pressed against the surface of the resist layer with pressure. By applying heat and/or light to the resist layer in this state, the resist layer is cured. Next, the mask is removed, and thereby the pattern, which is a pattern of the first penetrating portions 16 corresponding to the convex patterns, is formed on a surface of the resist layer. The first penetrating portions 16 can be formed by subsequently performing the aforementioned etching.

Next, the upper surface of the anode layer 12 and the inner surface of the anode layer 12 are covered with a dielectric body (FIG. 3C: dielectric layer forming process). In the exemplary embodiment, silicon dioxide (SiO₂) is used as the dielectric body for forming the dielectric layer 13. The dielectric layer 13 can be formed by a method similar to that of the method used to form the anode layer 12.

Next, the second penetrating portions 17 to penetrate the anode layer 12 and the dielectric layer 13 are formed (FIG. 3D: second penetrating portions forming process).

A method similar to that for forming the first penetrating portions 16 described above can be used as a method for forming the second penetrating portions 17. When etching is performed in this method, a bored portion may be formed in the substrate 11 by etching the surface of the substrate 11.

In the exemplary embodiment, it is preferable to transit to an organic compound layer forming process described next without removing the remaining resist layer lastly.

Next, the organic compound layer 14 that includes a light emitting layer formed to cover at least an inner surface of the second recessed portions 17 is formed (FIG. 3E: organic compound layer forming process).

For forming the organic compound layer 14, the method same as that in forming the anode layer 12 or the dielectric layer 13 can be used. It should be noted that formation of layers included in the organic compound layer 14 is preferably performed by a resistance heating deposition method or a coating method, and for forming a layer which includes macromolecular organic compounds, a coating method is especially preferable. When a layer is formed by a coating method, materials constituting the layer to be formed are applied to application liquid solution dispersed in a predetermined solvent such as an organic solvent or water. To perform coating, various methods such as a spin coating method, a spray coating method, a dip coating method, an ink-jet method, a slit coating method, a dispenser method and a printing method may be used. After the coating is performed, the light-emitting material solution is dried by heating or vacuuming, and thereby the layer to be formed is formed.

At this time, when the organic compound layer 14 is formed with remaining the resist layer that remained in the second penetrating portion forming process described above, the organic compound layer 14 is formed first of all in the second penetrating portions 17 and on the upper surface of this resist layer at the time of forming the organic compound layer 14. Then, when the resist layer is removed, the organic compound layer 14 on the upper surface of this resist layer is removed together, however, the organic compound layer 14 in the second penetrating portions 17 remains. That is, with this method, it is possible to selectively form the organic compound layer 14 in the second penetrating portions.

Next, the cathode layer 15 as a second electrode layer is formed on the organic compound layer 14 (FIG. 3F: second electrode layer forming process).

For forming the cathode layer 15, the method same as that in forming the anode layer 12 and the dielectric layer 13 can be used.

By the aforementioned processes, the organic light-emitting element 10 is manufactured.

Further, a protective layer or a protective cover (not shown) for stably using the organic light-emitting element 10 for long periods and protecting the organic light-emitting element 10 from outside may be mounted. As the protective layer, polymer compounds, metal oxides, metal fluorides, metal borides, or silicon compounds such as silicon nitrides and silicon oxides may be used. A lamination thereof may also be used. As the protective cover, glass plates, plastic plates with a surface treated with low hydraulic permeability, or metals may be used. The protective cover may be bonded to an element substrate by using a thermosetting resin or a photo-curable resin to be sealed. At this time, spacers may be used so that predetermined spaces are maintained, thus the prevention of scratches on the organic light-emitting element 10 is facilitated. Filling the spaces with inert gases such as nitrogen, argon and helium prevents the oxidation of the cathode layer 15 on the upper side. Especially, in a case of using helium, high thermal conductivity thereof enables heat generated from the organic light-emitting element 10 upon application of voltage to be effectively transmitted to the protective cover. In addition, by putting desiccants such as barium oxide in the spaces, the organic light-emitting element 10 is easily prevented from being damaged by moisture absorbed in the sequence of the aforementioned manufacturing processes.

The organic light-emitting element of the exemplary embodiment is preferably used for the display device as, for example, a pixel of matrix system or segment system. Further, the organic light-emitting element of the exemplary embodiment is also preferably used as a surface-emitting light source without forming a pixel. Specifically, the organic light-emitting element of the exemplary embodiment is preferably used as display devices in computers, televisions, mobile terminals, mobile phones, automobile navigation systems, traffic signs, advertising displays and viewfinders or the like of video cameras; and surface-emitting light sources in backlights, electrophotographics, illuminations, resist exposures, reading devices, interior illuminations, optical communication systems and the like.

### (Display device)

Next, description will be given for a display device having the aforementioned organic light-emitting element described in detail.

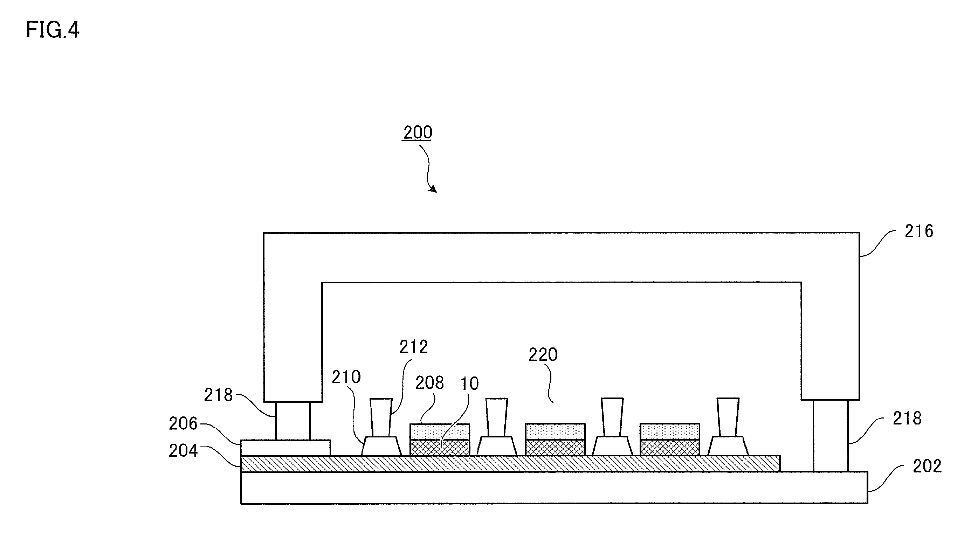

FIG. 4 is a diagram for illustrating an example of a display device using the organic light-emitting element 10 according to the exemplary embodiment.

A display device 200 shown in FIG. 4 is a so-called passive matrix display device, and is provided with a display device substrate 202, an anode wiring 204, an auxiliary anode wiring 206, a cathode wiring 208, an insulating film 210, a cathode partition 212, the organic light-emitting element 10, a sealing plate 216, and a sealant 218.

The display device substrate 202 may employ a transparent substrate such as a rectangular glass substrate. The thickness of the display device substrate 202 is not particularly limited; however, the thickness may be, for example, 0.1 mm to 1 mm.

On the display device substrate 202, plural anode wirings 204 are formed. The anode wirings 204 are arranged in parallel with certain intervals. The anode wiring 204 is configured with a transparent conductive film, and can be made of, for example, ITO (indium tin oxide). The thickness of the anode wiring 204 may be set to, for example, 100 nm to 150 nm. The auxiliary anode wiring 206 is formed on an end portion of each of the anode wirings 204. The auxiliary anode wiring 206 is electrically connected to the anode wiring 204. With such a configuration, the auxiliary anode wiring 206 functions as a terminal for connection to an external wiring on the end portion side of the display device substrate 202, and accordingly, a current is supplied from a not-shown drive circuit provided outside to the anode wirings 204 through the auxiliary anode wirings 206. The auxiliary anode wiring 206 may be configured with, for example, a metal film having a thickness of 500 nm to 600 nm.

Plural cathode wirings 208 are also provided on the organic light-emitting element 10. The plural cathode wirings 208 are arranged in parallel with each other, and each intersecting the anode wirings 204. Aluminum or aluminum alloy may be used for the cathode wiring 208. The thickness of the cathode wiring 208 is, for example, 100 nm to 150 nm. Further, similar to the auxiliary anode wiring 206 for the anode wirings 204, a not-shown auxiliary cathode wiring is provided on an end portion of each of the cathode wirings 208, and is electrically connected to the cathode wiring 208. Consequently, a current is capable of flowing between the cathode wirings 208 and the auxiliary cathode wirings.

On the display device substrate 202, the insulating film 210 is formed to cover the anode wirings 204. Opening portions 220 each having a rectangular shape are provided in the insulating film 210 to expose part of the anode wiring 204. The plural opening portions 220 are arranged in a matrix on the anode wirings 204. The organic light-emitting element 10 is provided at the opening portions 220 between the anode wirings 204 and the cathode wirings 208 as will be described later. In other words, each opening portion 220 becomes a pixel. Accordingly, a display region is formed corresponding to the opening portions 220. Here, the thickness of the insulating film 210 can be set to, for example, 200 nm to 300 nm, and the size of the opening portion 220 can be set to, for example, 300 µm square.

The organic light-emitting element 10 is formed at locations corresponding to the positions of the opening portions 220 on the anode wirings 204. The organic light-emitting element 10 is held between the anode wirings 204 and the cathode wirings 208 at the opening portion 220. In other words, the anode layer 12 and the cathode layer 15 of the organic light-emitting element 10 are in contact with the anode wirings 204 and the cathode wirings 208, respectively. The thickness of the organic light-emitting element 10 can be set to, for example, 150 nm to 200 nm.

On the insulating film 210, plural cathode partitions 212 are formed along the direction perpendicular to the anode wirings 204. The cathode partitions 212 play a role in spatially separating the plural cathode wirings 208 so that the cathode wirings 208 are not electrically connected to each other. Accordingly, each of the cathode wirings 208 is arranged between the adjacent cathode partitions 212. The size of the cathode partition 212 may be, for example, 2 µm to 3 µm in height and 10 µm in width.

The display device substrate 202 is bonded to the sealing plate 216 with the sealant 218. By this configuration, a space where the organic light-emitting element 10 is provided can be sealed, and thus the organic light-emitting element 10 can be prevented from deteriorating due to moisture in the air. As the sealing plate 216, for example, a glass substrate having a thickness of 0.7 mm to 1.1 mm can be used.

In the display device 200 with such a configuration, a current is supplied to the organic light-emitting element 10 via the auxiliary anode wirings 206 and the not-shown auxiliary cathode wirings from a not-shown driving device to cause the light emitting layer to emit light. By controlling light emission and non-light emission of the organic light-emitting element 10 corresponding to the aforementioned pixels with a controller, images can be displayed on the display device 200.

### (Illumination device)

Next, description will be given of an illumination device using the organic light-emitting element 10.

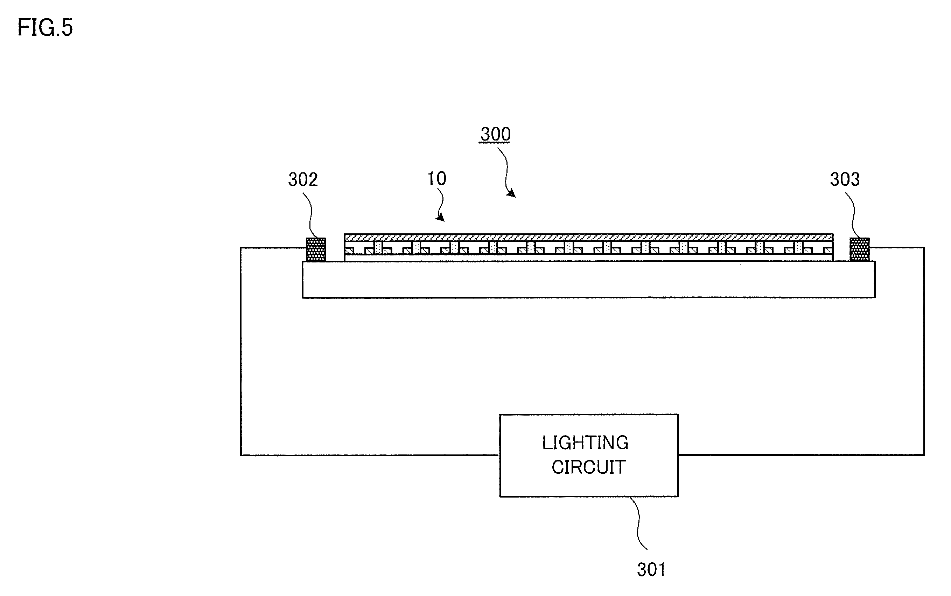

FIG. 5 is a diagram for illustrating a specific example of an illumination device having the organic light-emitting element 10 in the exemplary embodiment.

An illumination device 300 shown in FIG. 5 is configured with: the aforementioned organic light-emitting element 10; a terminal 302 that is provided adjacent to the substrate 11 (refer to FIG. 1) of the organic light-emitting element 10 and is connected to the anode layer 12 (refer to FIG. 1); a terminal 303 that is provided adjacent to the substrate 11 and is connected to the cathode layer 15 (refer to FIG. 1) of the organic light-emitting element 10; and a lighting circuit 301 that is connected to the terminals 302 and 303 to drive the organic light-emitting element 10.

The lighting circuit 301 has a not-shown DC power supply and a not-shown control circuit inside thereof, and supplies a current between the anode layer 12 and the cathode layer 15 of the organic light-emitting element 10 via the terminals 302 and 303. The lighting circuit 301 drives the organic light-emitting element 10 to cause the light emitting layer to emit light, the light is outputted from the first penetrating portions 16 or the second penetrating portions 17 (refer to FIG. 1) to the substrate 11, and the light is utilized for illumination. The light emitting layer may be configured with the light-emitting material that emits white light, or, it may be possible to provide plural organic light-emitting elements 10 using a light-emitting material that outputs each of the green light (G), blue light (B) and red light (R), thus making a synthetic light white. Note that, in the illumination device 300 according to the exemplary embodiment, when the light emission is performed with small diameter of the first penetrating portions 16 or the second penetrating portions 17 and small intervals between the first penetrating portions 16, the light emission seems to be surface emitting to the human eyes.

### Examples

### [Preparation of light-emitting material solution]

A phosphorescent light-emitting polymer compound (A) was prepared in accordance with the method disclosed in International Publication No. WO2010-016512. The weight-average molecular weight of polymer compound (A) was 52000, and molar ratio of each repeating unit was k : m : n = 6 : 42 : 52.

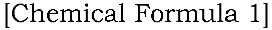

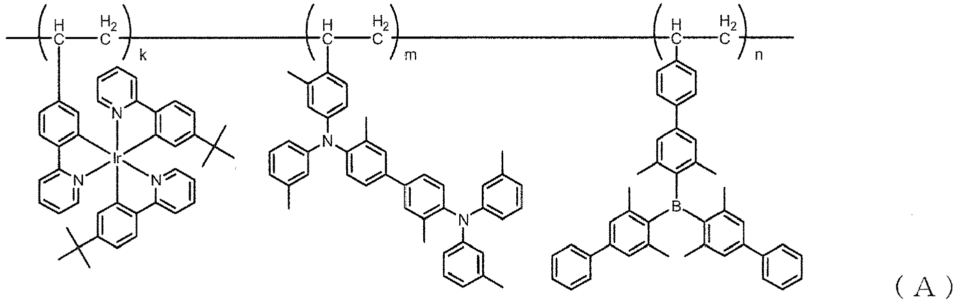

A light-emitting material solution (hereinafter, also referred to as "solution A") was prepared by dissolving 3 parts by weight of the light-emitting polymer compound prepared (A) in 97 parts by weight of toluene.

### [Preparation of organic light-emitting element]

### (Example 1)

As an organic light-emitting element, the organic light-emitting element 10 shown in FIG. 1 was produced by the method described below.

First, as the substrate 11, on a glass substrate made of fused quartz (25 mm per side, a thickness of 1mm) and a thin film of ITO (refractive index: 1.8) of 150 nm in thickness as the anode layer 12 were formed with a sputtering device (E-401s manufactured by Canon ANELVA Corporation).

Next, a photoresist layer (AZ1500 manufactured by AZ Electronic Materials) of about 1 µm in thickness was formed by a spin coating method. Then, on a quartz (having a thickness of 3 mm) as a substrate, a mask A corresponding to a pattern in which circles are arranged in a triangular lattice was produced, and exposure was performed on a scale of 1/5 by use of a stepper exposure device (NSR-1505i6 manufactured by Nikon Corporation). Next, development was executed with 1.2% aqueous solution of TMAH (tetramethyl ammonium hydroxide: (CH₃)₄NOH) for patterning the resist layer. Thereafter, heat at a temperature of 130°C was applied for 10 minutes (post-baking process).

Next, by use of a reactive ion etching device (RIE-200iP manufactured by SAMCO Inc.), dry etching process was performed by causing a reaction for 5 minutes with a mixed gas of Cl₂ and SiCl₄ as a reactant gas under conditions of a pressure of 1Pa and output bias/ICP = 200/100 (W). Then the plural first penetrating portions 16 were formed on the anode layer 12 by removing the residue of the resist by the resist removing solution. The first penetrating portions 16 had a cylindrical shape with a diameter of 1 µm, were arranged in a hexagonal lattice on the entire surface of the anode layer 12, and were formed so that a center-to-center distance (pitch) of the circle of the first penetrating portion 16 is 2-µm.

A SOG membrane (refractive index: 1.4) as the dielectric layer 13 was formed by heating process (80 degrees for three minutes, 150 degrees for three minutes, and 200 degrees for three minutes in the air) after applying a SOG solution (OCD T-7 manufactured by TOKYO OHKA KOGYO CO., LTD.) on the top surface of the anode layer 12 and inside of the first penetrating portion 16 by spin coating. The SOG membrane whose top surface is a flat surface had a thickness of 50 nm from the top surface of the anode layer 12.

Next, a photoresist layer is formed on the dielectric layer 13 by the similar method as forming the above first penetrating portions 16, and a patterning was performed with a mask B corresponding to the pattern in which circles are arranged in hexagonal lattice for forming the second penetrating portions 17. After that, the second penetrating portion 17 penetrating the dielectric layer 13 and the anode layer 12 was formed by performing dry etching process by causing a reaction of 5 minutes with a reactant gas as CHF₃ by use of the reactive ion etching device (RIE-200iP manufactured by SAMCO Inc.) under condition of a pressure 0.3Pa and output Bias/ICP=50/ 100(W). The second penetrating layers 17 were formed to have a cylindrical shape with diameter of 1 µm, and were formed to be arranged in a hexagonal lattice of 4-µm of center-to-center distance (pitch) of the circle directly above the first penetrating portion 16 on the entire surface of the dielectric layer 13 so that the center of the circle overlaps the center of the circle of the first penetrating portion 16.

The solution A was applied by the spin coating method (spin rate: 3000 rpm) and was left under a nitrogen atmosphere at the temperature of 140 °C for an hour to be dried. After leaving the dried layer for 5 seconds with toluene on top thereof and exposing the top portion of the photoresist layer, the substrate 11 was rotated with spin rate 3000 rpm and left under a nitrogen atmosphere at the temperature of 140 °C for an hour to be dried. The organic compound layer 14 (reflective index: 1.6) configured by a single light emitting layer was formed inside the second penetrating portion 17 by removing the residue of the resist.

Further, on the organic compound layer 14, a layer of sodium fluoride (4 nm) as the cathode buffer layer and a layer of aluminum (130 nm) as the cathode layer 15 were formed in order by a deposition method to prepare the organic light-emitting element 10.

### (Comparative Example 1)

The ITO membrane was prepared as anode layer on the glass substrate in the same manner as Example 1. The SOG membrane having a thickness of 50nm as the dielectric layer 13 was formed by performing heating process (80 degrees for three minutes, 150 degrees for three minutes, and 200 degrees for three minutes in the air) after applying the SOG solution (OCD T-7 manufactured by TOKYO OHKA KOGYO CO., LTD.) on the top surface of the anode layer by spin coating.

The photoresist pattern was formed with the mask B in the same manner as Example 1. A dry etching process was performed by causing a reaction of 5 minutes with a reactant gas as CHF₃ by use of the reactive ion etching device (RIE-200iP manufactured by SAMCO Inc.) under condition of a pressure 0.3Pa and output Bias/ICP=50/100(W). After that, the plural penetrating holes (corresponding to the second penetrating portions 17) penetrating the anode layer and the dielectric layer were formed by performing dry etching process by causing a reaction of 5 minutes with a mixed gas of Cl₂ and SiCl₄ in place of a reactant gas under condition of a pressure 1Pa and output Bias/ICP=200/100(W). The penetrating hole was formed to have a cylindrical shape with a diameter of 1 µm, was arranged in a hexagonal lattice on the entire surface of the anode layer and the dielectric layer so that the center-to-center distance (pitch) of the circle of the penetrating hole was 4 µm.

Next, the organic light emitting element was prepared by forming the cathode buffer layer and the cathode layer after forming the organic compound layer inside the above-described penetrating hole by applying the solution A and removing the residue of the resist in the same manner as Example 1.

The organic light emitting element which was not provided with the first penetrating portion 16 was prepared by the above-described process applied to the organic light emitting element 10 prepared in the Example 1.

### (Comparative Example 2)

An organic light-emitting element was prepared in the same manner as Comparative Example 1 except that mask A was used instead of the mask B used for patterning the photoresist layer.

### [Evaluation Method]

Voltage was applied in a step-by-step manner to the organic light-emitting elements prepared in Example 1, Comparative Examples 1 and 2 by a DC power supply (SM2400 manufactured by Keithley Instruments Inc.), and light emitting intensity of the organic light-emitting elements was measured by a luminance meter (BM-9 manufactured by TOPCON CORPORATION). Then, light emission efficiency was determined by the rate of light emitting intensity with respect to the current density.

### [Evaluation Result]

The results are shown in the Table 1 below. Regarding the light emission efficiency, the results mean that the light emission efficiency is better as the shown values are larger.

**[Table 1]**

| | First Penetrating Portion | | Second Penetrating Portion | | Light Emission Efficiency (cd/A) |
|---|---|---|---|---|---|
| | Width (µm) | Pitch (µm) | Width (µm) | Pitch (µm) | |
| Example 1 | 1 | 2 | 1 | 4 | 74 |
| Comparative Example 1 | - | - | 1 | 4 | 44 |
| Comparative Example 2 | - | - | 1 | 2 | 50 |

It can be seen that the light emission efficiency of the organic light-emitting element 10 in the exemplary embodiment in which the first penetrating portions 16 filled with the dielectric layer 13 are formed in the anode layer 12 is higher compared to the Comparative Examples 1 and 2 in which such first penetrating portions are not formed and the organic light-emitting element 10 in the exemplary embodiment has a configuration with high light emission efficiency.

### Reference Signs List

- 10: Organic light-emitting element
- 11: Substrate
- 12: Anode layer
- 13: Dielectric layer
- 14: Organic compound layer
- 15: Cathode layer
- 16: First penetrating portion
- 17: Second penetrating portion
- 200: Display device
- 300: Illumination device

## Claims

1. An organic light-emitting element comprising:
a first electrode layer that is transparent and formed on a substrate;
a first penetrating portion that is formed to penetrate the first electrode layer;
a dielectric layer that is formed to cover an upper surface of the first electrode layer and an inner surface of the first penetrating portion;
a second penetrating portion that is formed to penetrate the first electrode layer and the dielectric layer;
an organic compound layer that includes a light emitting layer formed to cover at least an inner surface of the second penetrating portion; and
a second electrode layer that is formed on the organic compound layer, wherein
a refractive index of the dielectric layer is lower than a refractive index of the first electrode layer.

2. The organic light-emitting element according to claim 1, wherein an upper surface of the dielectric layer is formed to be a planar shape.

3. The organic light-emitting element according to any one of claims 1 and 2, wherein the refractive index of the dielectric layer is lower than a refractive index of the organic compound layer.

4. The organic light-emitting element according to any one of claims 1 to 3, wherein
the first penetrating portion and the second penetrating portion have a circular shape or a polygonal shape with the maximum width of 10 µm or less in an area surface of the first electrode layer, and
the first penetrating portion and the second penetrating portion are formed 10³ to 10⁸ per 1 mm square in an arbitrary area surface of the first electrode layer.

5. A method for making an organic light-emitting element comprising:
a first electrode layer forming process in which a first electrode layer is laminated on a substrate;
a first penetrating portion forming process in which a first penetrating portion is formed to penetrate the first electrode layer;
a dielectric layer forming process in which an upper surface of the first electrode layer and an inner surface of the first penetrating portion are covered with a dielectric body;
a second penetrating portion forming process in which a second penetrating portion is formed to penetrate the first electrode layer and the dielectric layer;
an organic compound layer forming process in which an organic compound layer that includes a light emitting layer formed to cover at least an inner surface of the second penetrating portion is formed; and
a second electrode layer forming process in which a second electrode is formed on the organic compound layer.

6. A display device comprising the organic light-emitting element according to any one of claims 1 to 4.

7. An illumination device comprising the organic light-emitting element according to any one of claims 1 to 4.
